# EUROPEAN PATENT APPLICATION

(11) **EP 3 023 515 A2**
(43) Date of publication of application: **25.05.2016**
(21) Application number: 15193850.3
(22) Date of filing: 10.11.2015
(51) Int. Cl.: C23C 18/18, C23C 18/34, C23C 18/40, C23C 18/44, C23C 18/50, C23C 18/52

(54) **FORMALDEHYDE-FREE ELECTROLESS METAL PLATING COMPOSITIONS AND METHODS**

(30) Priority: 24.11.2014 US 201414552478
(71) Applicant: Rohm and Haas Electronic Materials LLC, Marlborough, MA 01752 (US)
(72) Inventor: WU, Weigang, Fanling (HK); LI, Crystal P. L, N.T (HK); LIANG, Zhixiong, Fanling (HK)
(74) Representative: Houghton, Mark Phillip

(57) **Abstract**

Formaldehyde-free electroless metal plating solutions include glyoxylic acid or salts thereof in combination with tertiary amines which stabilize the glyoxylic acid and salts. The electroless metal plating solutions are environmentally friendly, stable and deposit bright metal deposits on substrates.

## Description

### Field of the Invention

The present invention is directed to environmentally friendly, formaldehyde-free electroless metal plating compositions and methods containing glyoxylic acid and salts thereof and tertiary amines. More specifically, the present invention is directed to environmentally friendly, formaldehyde-free electroless metal plating compositions and methods containing glyoxylic acid and salts thereof and tertiary amines to inhibit decomposition of the glyoxylic acid and salts thereof.

### Background of the Invention

Electroless metal plating compositions such as electroless copper plating compositions are in widespread use in metallization industries for depositing copper and other metals on various types of substrates. In the manufacture of printed wiring boards, for example, the electroless copper baths are used to deposit copper into through-holes and circuit paths as a base for subsequent electrolytic copper plating. Electroless copper and other electroless metal plating compositions also are used in the decorative plastics industry for deposition of metals onto non-conductive surfaces as a base for further plating of copper, nickel, gold, silver and other metals as required. Typical electroless copper plating baths which are in commercial use today contain divalent copper compounds, chelating agents or complexing agents for the divalent copper ions, formaldehyde reducing agents and various addition agents to make the bath more stable, adjust the plating rate and brighten the copper deposit. Although many of such baths are successful and are widely used, the metallization industry has been searching for alternative electroless copper plating baths that do not contain formaldehyde due to its toxic nature.

Formaldehyde is known as an eye, nose and upper respiratory tract irritant. Animal studies have shown that formaldehyde is an *in vitro* mutagen. According to a WATCH committee report (WATCH/2005/06 - Working group on Action to Control Chemicals - sub committee with UK Health and Safety Commission) over fifty epidemiological studies have been conducted prior to 2000 suggested a link between formaldehyde and nasopharyngeal/nasal cancer but were not conclusive. However, more recent studies conducted by IARC (International Agency for Research on Cancer) in the U.S.A. showed that there was sufficient epidemiological evidence that formaldehyde causes nasopharyngeal cancer in humans. As a result the INRS, a French agency, has submitted a proposal to the European Community Classification and Labelling Work Group to reclassify formaldehyde from a category 3 to a category 1 carcinogen. This would make usage and handling of it more restricted, including in electroless copper formulations. Accordingly, there is a need in the metallization industry for a comparable or improved reducing agent to replace formaldehyde. Such a reducing agent must be compatible with existing electroless copper processes; provide desired capability and reliability and meet cost targets.

To address the problems of formaldehyde, researchers have attempted to use glyoxylic acid or its salts as a formaldehyde replacement; however, glyoxylic acid and its salts have a high decomposition rate which compromises its performance as an acceptable substitute for formaldehyde. One of the most likely decomposition pathways is the Cannizzaro reaction:

2CHOCOO⁻ + OH⁻ →C₂O₄²⁻ + HOCH₂COO⁻

Similar to formaldehyde, glyoxylic acid disproportionates to form oxalate and glycolate under strong basic conditions. The Cannizzaro effect of glyoxylic acid is more serious than that of formaldehyde. Thus it can be seen that glyoxylic acid concentration drops sharply in the bath solution, and results in termination of electroless copper plating unless replenished with more of the reducing agent. Accordingly, the operating cost is very high. Examples of attempts to arrest the decompositions of glyoxylic acid via the Cannizzaro reaction are disclosed in U.S. 2003/0054094 to Itabashi et al. and U.S. 2003/0183120 also to Itabashi et al. U.S. 2003/0054094 alleges that Cannizzaro reaction may be inhibited by including certain molar amounts of methanol, primary amines, secondary amines, metasilicic acid and its salts, phosphoric acid and its salts, germanium dioxide, vanadic acid and its salts in the electroless copper plating solution. U.S. 2003/0183120 alleges that including succinic acid in the electroless copper plating solution may inhibit the Cannizzaro reaction.

Although there are methods which may inhibit the Cannizzaro reaction and inhibit the decomposition of glyoxylic acid in electroless metal plating solutions, there is still a need to provide an electroless metal plating solution which prevents or reduces the decomposition of glyoxylic acid, is environmentally friendly and provides uniform, bright metal deposits on substrates.

### Summary of the Invention

Compositions include one or more sources of metal ions, one or more sources of glyoxylic acid, salts or mixtures thereof and one or more tertiary amine compounds, salts or halides thereof having a formula: 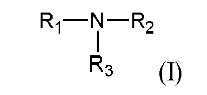 where R1, R₂ and R₃ may be the same or different and are linear or branched, substituted or unsubstituted hydroxy(C₁-C₁₀)alkyl, linear or branched, substituted or unsubstituted carboxy(C₁-C₁₀)alkyl, linear or branched, substituted or unsubstituted (C₁-C₁₀)alkylamine, linear or branched, substituted or unsubstituted (C₁-C₁₀)alkyl phosphonic acid or a moiety having a formula: 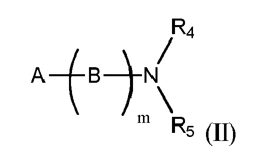 where R₄ and R₅ may be the same or different and are linear or branched, substituted or unsubstituted hydroxy(C₁-C₁₀)alkyl, linear or branched, substituted or unsubstituted carboxy(C₁-C₁₀)alkyl, linear or branched, substituted or unsubstituted (C₁-C₁₀)alkylamine, linear or branched, substituted or unsubstituted (C₁-C₁₀)alkyl phosphonic acid, or moiety -(CH₂)ₐ-N-((CH₂)_{b})₂-(P(O)(OH)₂) (IIa) where a and b may be the same or different and are integers of 1 to 6, m is an integer from 1 to 6, B is a moiety having a formula: 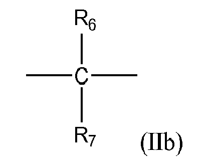 where R₆ and R₇ may be the same or different and are hydrogen, hydroxyl, carboxyl, hydroxy(C₁-C₃)alkyl, carboxy(C₁-C₃)alkyl, or (C₁-C₃)alkyl, or B may be a substituted or unsubstituted (C₅-C₆)cycloalkyl ring and m = 1, A is a chemical bond with the nitrogen of formula (I) or a moiety having a formula: 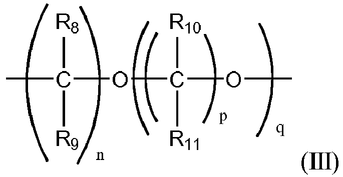 wherein R₈, R₉, R₁₀ and R₁₁ are the same or different and are hydrogen, hydroxyl or (C₁-C₃)alkyl, n, p, q may be the same or different and are integers of 1 to 6, with the proviso that when any two of R₁, R₂ and R₃ are carboxymethyl moieties or salts thereof the third cannot be formula (II) where A is a chemical bond, B is formula (IIb), m is 2, R₆ and R₇ are hydrogen and R₄ and R₅ are carboxymethyl moieties or salts thereof; and a molar ratio of the one or more tertiary amine compounds to the glyoxylic acid or salts thereof is 0.05:1 to 15:1, the compositions are formaldehyde- free.

Methods include providing a substrate and applying the composition including the one or more sources of metal ions, glyoxylic acid, salts or mixtures thereof and one or more of the tertiary amines, salts, halides or mixtures thereof to the substrate; and electroless plating copper on the substrate.

The combination of the one or more tertiary amines and glyoxylic acid, salts or mixtures thereof provide a stable electroless metal plating composition which is formaldehyde-free and environmentally friendly. The tertiary amines inhibit the decomposition of glyoxylic acids and its salts, thus prolonging the life of the plating composition and reducing the cost of the operation of the plating composition as replacement with glyoxylic acid or its salts is reduced or eliminated. The combination of the one or more tertiary amines, salts, halides or mixtures thereof and the glyoxylic acid, salts or mixtures thereof at the molar ratios provides for a more efficient electroless metal plating process than many conventional electroless metal compositions and plating processes. In addition, the plating compositions may provide for substantially uniform, bright metal deposits on substrates and reduced skip plating.

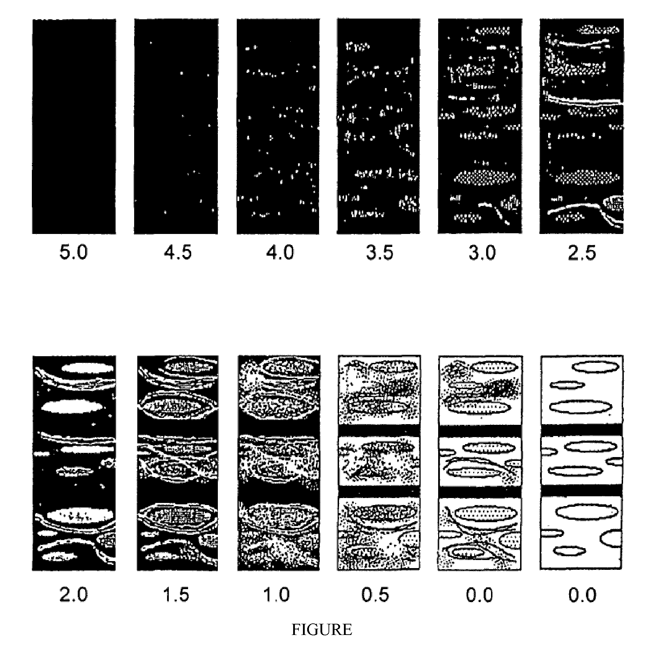

### Brief Description of the Drawing

Figure illustrates the European Backlight Reference Plates for determining metal plating coverage performance of through-holes of printed circuit boards for electroless copper plating.

### Detailed Description of the Invention

As used throughout this specification, the abbreviations given below have the following meanings, unless the context clearly indicates otherwise: g = gram; mg = milligram; mL = milliliter; L = liter; cm = centimeter; m = meter; mm = millimeter; µm = micron; ppm = parts per million; °C = degrees Centigrade; M = molar; g/L = grams per liter; v = volume; wt% = percent by weight; RO = reverse osmosis; DI = deionized; T_{g} = glass transition temperature; EDTA = ethylenediaminetetraacetic acid; K = potassium; Na = sodium; Fe = iron; and CN = cyanide.

The terms "printed circuit board" and "printed wiring board" are synonymous. The terms "plating" and "deposition" are used interchangeably throughout this specification. The term "moiety" means a part of a molecule or polymer that may include either whole functional groups or parts of functional groups as substructures. The term "halide" means chloride, bromide, fluoride or iodide. All amounts are percent by weight, unless otherwise noted. All numerical ranges are inclusive and combinable in any order except where it is logical that such numerical ranges are constrained to add up to 100%.

Aqueous based electroless metal plating compositions include one or more sources of metal ions, glyxoylic acid, salts of glyoxylic acid or mixtures thereof as reducing agents for the metal ions and one or more tertiary amine compounds, salts and halides thereof having a formula: 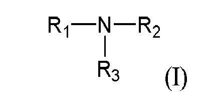 where R₁, R₂ and R₃ may be the same or different and are linear or branched, substituted or unsubstituted hydroxy(C₁-C₁₀)alkyl, linear or branched, substituted or unsubstituted carboxy(C₁-C₁₀)alkyl, linear or branched, substituted or unsubstituted (C₁-C₁₀)alkylamine, linear or branched, substituted or unsubstituted (C₁-C₁₀)alkyl phosphonic acid or a moiety having a formula: 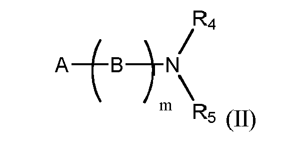 where R₄ and R₅ may be the same or different and are linear or branched, substituted or unsubstituted hydroxy(C₁-C₁₀)alkyl, linear or branched, substituted or unsubstituted carboxy(C₁-C₁₀)alkyl, linear or branched, substituted or unsubstituted (C₁-C₁₀)alkylamine, linear or branched, substituted or unsubstituted (C₁-C₁₀)alkyl phosphonic acid, or moiety -(CH₂)ₐ-N-((CH₂)_{b})₂-(P(O)(OH)₂) (IIa) where a and b may be the same or different and are integers of 1 to 6, m is an integer from 1 to 6, B is a moiety having formula: 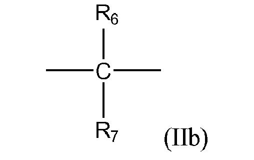 R₆ and R₇ may be the same or different and are hydrogen, hydroxyl, carboxyl, hydroxy(C₁-C₃)alkyl, carboxy(C₁-C₃)alkyl, or (C₁-C₃)alkyl, or B may be a substituted or unsubstituted (C₅-C₆)cycloalkyl ring and m = 1, A is a chemical bond with the nitrogen of formula (I) or a moiety having a formula: 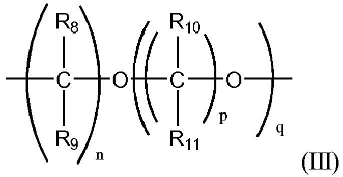 wherein R₈, R₉, R₁₀ and R₁₁ are the same or different and are hydrogen, hydroxyl or (C₁-C₃)alkyl, n, p and q may be the same or different and are integers of 1 to 6, with the proviso that when any two of R₁, R₂ and R₃ are carboxymethyl moieties or salts thereof the third cannot be formula (II) where A is a chemical bond, B is formula (IIb), m is 2, R₆ and R₇ are hydrogen and R₄ and R₅ are carboxymethyl moieties or salts thereof; and a molar ratio of the one or more tertiary amine compounds to the glyoxylic acid or salts thereof is 0.05:1 to 15:1.

Preferably R₁, R₂ and R₃ may be the same or different and are linear or branched, substituted or unsubstituted hydroxy(C₁-C₆)alkyl, linear or branched, substituted or unsubstituted carboxy(C₁-C₆)alkyl, linear or branched, substituted or unsubstituted (C₁-C₆)alkylamine, linear or branched, substituted or unsubstituted (C₁-C₆)alkyl phosphonic acid or a moiety having a formula: 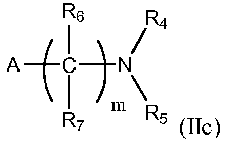 where R₄ and R₅ may be the same or different and are linear or branched, substituted or unsubstituted hydroxy(C₁-C₆)alkyl, linear or branched, substituted or unsubstituted carboxy(C₁-C₆)alkyl, linear or branched, substituted or unsubstituted (C₁-C₆)alkylamine, linear or branched, substituted or unsubstituted (C₁-C₆)alkyl phosphonic acid, or moiety -(CH₂)ₐ-N-((CH₂)_{b})₂-(P(O)(OH)₂) (IIa) where a and b may be the same or different and are integers of 1 to 3, m is an integer from 1 to 3, R₆ and R₇ may be the same or different and are hydrogen, hydroxyl, carboxyl, hydroxy(C₁-C₂)alkyl, carboxy(C₁-C₂)alkyl, or (C₁-C₂)alkyl, A is a chemical bond with the nitrogen of formula (I) or a moiety having a formula: 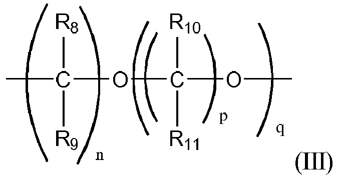 wherein R₈, R₉, R₁₀ and R₁₁ are the same or different and are hydrogen, hydroxyl or (C₁-C₂)alkyl, n, p, q may be the same or different and are integers of 1 to 3.

More preferably, R₁, R₂ and R₃ may be the same or different and are linear or branched, substituted or unsubstituted hydroxy(C₁-C₄)alkyl, linear or branched, substituted or unsubstituted carboxy(C₁-C₄)alkyl, linear or branched, substituted or unsubstituted (C₁-C₄)alkylamine, linear or branched, substituted or unsubstituted (C₁-C₄)alkyl phosphonic acid or a moiety having a formula: 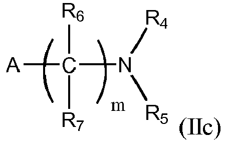 where R₄ and R₅ may be the same or different and are hydroxy(C₁-C₃)alkyl, or carboxy(C₁-C₃)alkyl, m is an integer from 2 to 3, R₆ and R₇ may be the same or different and are hydrogen, hydroxyl, carboxyl, or (C₁-C₂)alkyl, and A is a chemical bond with the nitrogen of formula (I).

Salts of the foregoing tertiary amine compounds include, but are not limited to alkali metal salts, such as potassium, sodium and lithium salts and ammonium salts. Preferably the salts are alkali metal salts such as potassium and sodium, more preferably the salt is sodium.

Halides are Cl⁻, F⁻, Br⁻ and I⁻. Sources of halides include, but are not limited to hydrogen chloride, hydrogen bromide, hydrogen fluoride and hydrogen iodide. Preferably the source of halides is hydrogen chloride.

Substituent groups include, but are not limited to hydroxyl, linear or branched hydroxy(C₁-C₄)alkyl, carboxyl, linear or branched carboxy(C₁-C₄)alkyl, linear or branched (C₁-C₄)alkyl or an amine moiety having formula: 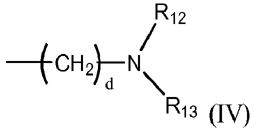 where R₁₂ and R₁₃ may be the same or different and are hydrogen or linear or branched (C₁-C₄)alkyl, hydroxy(C₁-C₃)alkyl, or carboxy(C₁-C₃)alkyl and d is an integer of 1 to 3. Preferably substituent groups are hydroxyl, carboxyl or (C₁-C₃)alkyl.

Examples of the foregoing tertiary amines are triethanolamine, 2-[bis(2-hydroxyethyl)amino]acetic acid and its salts, N-(2-hydroxyethyl)iminodiacetic acid and its salts, nitrilotriacetic acid, nitrile(3-propionic)diacetic acid and its salts, nitriltripropionic acid and its salts, *N,N-*bis(2-hydroxypropyl)ethanolamine, 1-[bis(2-hydroxyethyl)amino]-2-propanol, 2-[bis(2-hydroxyethyl)amino]-2-(hydroxymethyl) -1,3-propanediol, *N,N*-Bis(carboxymethyl)-DL-alanine and its salts, triisopropanolamine, L-glutamic acid *N,N'*-diacetic acid and its salts, *N,N,N',N'*-tetrakis(2-hydroxypropyl) ethylenediamine, *N,N,N',N'*-tetrakis(2-hydroxyethyl) ethylenediamine, 1,3-Diamino-2- hydroxypropane-*N,N,N',N'*-tetraacetic acid and its salts, ethylenediaminetetrapropionic acid and its salts, propylenediaminetetraacetic acid and its salts, *N*-(2-hydroxyethyl) ethylenediamine-*N,N,N'*-triacetic acid and its salts, diethylenetriamine pentaacetic acid and its salts, triethylenetetramine-*N,N,N',N",N"',N"'*-hexaacetic acid and its salts, methyl diethanolamine, methyliminodiacetic acid and its salts, tris(carboxymethyl)ethylenediamine, 1,2-diaminocyclohexanetetraacetic acid and its salts, N-(2-aminoethyl)-trans-1,2-diaminocyclohexane-N,N,N -pentaacetic acid and its salts, ethylene glycol tetraacetic acid and its salts, diethylene triamine pentamethylene phosphonic acid and its salts, (ethylenedinitrilo)-tetramethylenephosphonic acid and its salts, (nitrilotrimethylene)triphosphonic acid and its salts.

The electroless plating compositions are formaldehyde-free, thus enabling environmentally friendly electroless metal plating compositions. The tertiary amines suppress unwanted decomposition of glyoxylic acid and its salts to provide a more efficient and reliable electroless plating composition. The compositions are also free of ethylenediamine tetraacetic acid and its salts.

Sources of glyoxylic acid include non-dissociated glyoxylic acid, salts of glyoxylic acid such as alkali metal salts of glyoxylic acid, such as sodium and potassium salts, and those reducing agents that can provide glyoxylate ions in an alkaline solution such as dihydroxy acetic acid, a dihaloacetic acid and the bisulphite adduct of glyoxylic acid. Preferably the source of the reducing agent is glyxoylic acid. The concentration range may be from 0.1 g/L to 100 g/L, preferably from 1 g/L to 50 g/L.

The amount of the tertiary amine included in the electroless compositions is based on a molar ratio of tertiary amine to glyoxylic acid. The molar ratio of the tertiary amine suppressor to glyoxylic acid in the electroless composition is in a range of 0.05:1 to 15:1. When the molar ratio is lower than 0.05:1, the suppressor does not effectively suppress glyoxylic acid decomposition. When the molar ratio is greater than 15:1, the suppressor substantially hinders plating performance. Preferably the molar ratio of tertiary amine to glyoxylic acid is 0.2:1 to 10:1, more preferably 0.4:1 to 10:1.

Metals which may be plated include, but are not limited to copper, gold, silver, nickel and tin. Preferably the metals are copper, tin and nickel, more preferably the metals are copper and nickel. Most preferably the metal is copper. Alloys which may be plated include but are not limited to binary alloys such as copper/tin and copper nickel alloys and ternary alloys such as copper/tin/silver. Conventional sources of metal ions which are soluble in an aqueous medium may be used. Conventional amounts of metal ions for electroless plating may be used.

Sources of copper ions include, but are not limited to water soluble halides, nitrates, acetates, sulfates and other organic and inorganic salts of copper. Mixtures of one or more of such copper salts may be used to provide copper ions. Examples include copper sulfate, such as copper sulfate pentahydrate, copper chloride, copper nitrate, copper sulfamate, copper hydroxide, and copper methane sulfonate ((CH₃O₃S)₂Cu). Copper ion concentrations in the composition may range from 0.25 g/L to 30 g/L or such as from 0.5 g/L to 20 g/L or such as from 1 g/L to 10 g/L.

Sources of nickel ions include, but are not limited to nickel sulfate, nickel chloride, nickel sulfamate, and nickel phosphate. Mixtures of nickel compounds may be used in the plating compositions. The nickel compounds may be added to the plating compositions in amounts sufficient to provide a nickel ion concentration in the plating composition of 0.1 g/L to 50 g/L, or such as 0.5 g/L to 30 g/L, or such as 1 g/L to 20 g/L.

Sources of tin ions include, but are not limited to salts, such as tin halides, tin sulfates, tin alkane sulfonates, tin alkanol sulfonates, and acids. When tin halide is used, it is typical that the halide is chloride. The tin compound is typically tin sulfate, tin chloride or a tin alkane sulfonate, and more typically tin sulfate or tin methane sulfonate. Sufficient amounts of tin salts are added to the electroless composition to provide tin (II) ions in amounts of 0.5 g/L to 80 g/L, typically from 5 g/L to 50 g/L.

Sources of silver ions may be provided by silver salts such as, but are not limited to silver halides, silver gluconate, silver citrate, silver lactate, silver nitrate, silver sulfates, silver alkane sulfonates and silver alkanol sulfonates. When a silver halide is used, it is typical that the halide is chloride. Typically the silver salts are silver sulfate, a silver alkane sulfonate or mixtures thereof, and more typically silver sulfate, silver methane sulfonate or mixtures thereof. Sufficient amounts of silver salts are added to the electroless plating composition to provide silver ions in amounts of 0.01 g/L to 60 g/L, typically from 0.02 g/L to 30 g/L.

Sources of gold ions include, but are not limited to one or more gold salts which provide gold (I) ions. Such sources of gold (I) ions include, but are not limited to alkali gold cyanide compounds such as potassium gold cyanide, sodium gold cyanide, and ammonium gold cyanide, alkali gold thiosulfate compounds such as trisodium gold thiosulfate and tripotassium gold thiosulfate, alkali gold sulfite compounds such as sodium gold sulfite and potassium gold sulfite, ammonium gold sulfite, and gold (I) and gold (III) halides such as gold (I) chloride and gold (III) trichloride. Sufficient amounts of gold sources are added to the electroless plating compositions to provide gold ion concentrations of 0.5 g/L to 50 g/L, or such as from 5 g/L to 30 g/L, or such as from 10 g/L to 20 g/L.

In addition to the foregoing components, the electroless metal plating composition may include one or more optional additives to tailor the compositions to a desired plating performance for a given application. Such optional additives include, but are not limited to accelerators, uniformity enhancers, stabilizers, grain-refiners, complexing agents, chelating agents, additional reducing agents, pH adjusting agents, antioxidants and surfactants.

Uniformity enhancers with an ability to enhance the initiation of electroless plating include but are not limited to aldehydes such as glyoxal, succindialdehyde, glucose and acetaldehyde. Such aldehydes may be included in the electroless metal plating compositions in amounts of 0.01 g/L to 10 g/L, preferably from 0.5 g/l to 5 g/L.

Except for formaldehyde, one or more additional reducing agents may include, but are not limited to hypophosphite, glycolic acid, glyoxal, ascorbic acid, formic acid and glycine. The additional reducing agents may be used in their conventional amounts.

Complexing agents include, but are not limited to ethylenediamine-*N,N'*-disuccinic acid (EDDS) and its salts, Rochelle salts, potassium tartrate, citric acid and its salts, ethanoldiamine, Iminodiacetic acid and its salts, pyrophosphoric acid and its salts, salicylic acid and its salts, hydroxyethylidene diphosphonic acid and its salts, xylitol and D-sorbitol. The molar ratio of complexing agents to metal ions may range from 0.5:1 to 50:1 or such as from 1:1 to 15: 1 or such as from 1.2:1 to 8: 1.

Stabilizers include, but are not limited to sulfur containing compounds such as 2-mercaptopyridine, 2-mercaptobenzothiazole, 2-mercaptothiazoline, mercaptobenzothiazole, thiourea and its derivatives; cyanides such as KCN, NaCN, K₄[Fe(CN)₆], thiocyanates; dipyridyls and its derivatives such as 2,2'-dipyridyl, methylpiperidine, 1,2-di-(2-pyridyl)ethylene, 2,2'-dipyridylamine, pyridazine, 6,6'-dimethyl-2,2'dipyridyl, di-2-pyrylketone and 2,2'-bipyrimidine. Such stabilizers may be included in amounts of 1ppm to 10 g/L.

Optional grain-refining additives include, but are not limited to high molecular weight polymer compounds such as polyalkylene glycols, ployacrylamides, poly acrylates, polypropylene glycols, polyethylene glycols (PEG). Some are available in various molecular weights such as PEG which may be available as PEG 600, PEG 2000, PEG 4000, PEG 6000 and PEG 10000. The grain-refining additives are included in amounts of 0.1 ppm to 300 ppm, preferably 1 ppm to 100 ppm.

Rate-accelerating additives include, but are not limited to sulfur-based organic molecules such as bis(sodium sulfopropyl) disulfide, sodium 3-(benzothiazol-2-ylthio)-1-propanesulfonate and other disulfides. Such compounds are included in amounts of 0.1 ppm to 30 ppm, preferably from 0.5 ppm to 10 ppm. Other rate accelerating additives include, but are not limited to ammonia, ethylenediamine and mannitol. Such rate-accelerating compounds may be included in amounts of 0.01 g/L to 5 g/L.

Typically, the pH of the composition is adjusted by one or more alkaline compounds chosen from lithium hydroxide, sodium hydroxide, potassium hydroxide and ammonium hydroxide to provide a pH greater than 7, typically 8 and greater. In the field of ultra large scale integrated (ULSI), organic alkalis such as tetramethyl ammonium hydroxide (TMAH) are used for pH adjustment to avoid the introduction of alkaline metal ions onto the surface or into the plated copper coating. More typically, sodium hydroxide, potassium hydroxide and TMAH or mixtures thereof are used. Preferably potassium hydroxide is used because potassium oxalate has a higher solubility than that of sodium oxalate. Preferably the potassium hydroxide concentration is from 3 g/L to 100 g/L, more preferably from 10 g/L to 80 g/L. A preferred pH range of the electroless metal compositions is from 10 to 14, more preferably from 11.5 to 13.5, most preferably from 12.5 to 13.5.

Conventional surfactants may be included in the compositions. Such surfactants include ionic, such as cationic and anionic surfactants, non-ionic and amphoteric surfactants. Mixtures of the surfactants may be used. In general, surfactants may be included in conventional amounts for electroless copper plating compositions. Surfactants may be included in the compositions in amounts of 0.001 g/L to 50 g/L.

Cationic surfactants include, but are not limited to tetra-alkylammonium halides, alkyltrimethylammonium halides, hydroxyethyl alkyl imidazoline, alkylbenzalkonium halides, alkylamine acetates, alkylamine oleates and alkylaminoethyl glycine.

Anionic surfactants include, but are not limited to alkylbenzenesulfonates, alkyl or alkoxy naphthalene sulfonates, alkyldiphenyl ether sulfonates, alkyl ether sulfonates, alkylsulfuric esters, polyoxyethylene alkyl ether sulfuric esters, polyoxyethylene alkyl phenol ether sulfuric esters, higher alcohol phosphoric monoesters, polyoxyalkylene alkyl ether phosphoric acids (phosphates) and alkyl sulfosuccinates.

Amphoteric surfactants include, but are not limited to 2-alkyl-N-carboxymethyl or ethyl-N-hydroxyethyl or methyl imidazolium betaines, 2-alkyl-N-carboxymethyl or ethyl-N-carboxymethyloxyethyl imidazolium betaines, dimethylalkyl betains, N-alkyl-β-aminopropionic acids or salts thereof and fatty acid amidopropyl dimethylaminoacetic acid betaines.

Preferably the surfactants are non-ionic. Non-ionic surfactants include, but are not limited to are alkyl phenoxy polyethoxyethanols, polyoxyethylene polymers having from 20 to 150 repeating units and block and random copolymers of polyoxyethylene and polyoxypropylene.

Antioxidants include, but are not limited to monohydric, dihydric and trihydric phenols in which a hydrogen atom or atoms may be unsubstituted or substituted by -COOH, -SO₃H, lower alkyl or lower alkoxy groups, hydroquinone, catechol, resorcinol, quinol, pyrogallol, hydroxyquinol, phloroglucinol, guaiacol, gallic acid, 3,4-dihydroxybenzoic acid, phenolsulfonic acid, cresolsulfonic acid, hydroquinonsulfonic acid, catecholsulfonic acid and salts thereof. Antioxidants may be included in the compositions in conventional amounts typically used for electroless copper compositions such as from 1 ppm to 1000 ppm.

The electroless metal compositions may be used to deposit a metal on both conductive and non-conductive substrates. The electroless compositions may be used in many conventional methods known in the art. Typically copper deposition is done at temperatures of 20° C to 80° C. Preferably the electroless compositions deposit copper at temperatures of 20° C to 60° C. The substrate to be plated with copper is immersed in the electroless composition or the electroless composition is sprayed onto the substrate. Conventional plating times may be used to deposit the copper onto the substrate. Deposition may be done for 5 seconds to 30 minutes; however, plating times may vary depending on the thickness of the metal desired on the substrate and the plating bath temperature. Metal plating rates may range from 0.15 µm/5 minutes to 0.5 µm/5 minutes, preferably from 0.25 µm/5 minutes to 0.45 µm/5 minutes.

Substrates include, but are not limited to materials including inorganic and organic substances such as glass, ceramics, porcelain, resins, paper, cloth and combinations thereof. Metal-clad and unclad materials also are substrates which may be plated with the electroless copper compositions.

Substrates also include printed circuit boards. Such printed circuit boards include metal-clad and unclad with thermosetting resins, thermoplastic resins and combinations thereof, including fiber, such as fiberglass, and impregnated embodiments of the foregoing.

Thermoplastic resins include, but are not limited to acetal resins, acrylics, such as methyl acrylate, cellulosic resins, such as ethyl acetate, cellulose propionate, cellulose acetate butyrate and cellulose nitrate, polyethers, nylon, polyethylene, polystyrene, styrene blends, such as acrylonitrile styrene and copolymers and acrylonitrile-butadiene styrene copolymers, polycarbonates, polychlorotrifluoroethylene, and vinylpolymers and copolymers, such as vinyl acetate, vinyl alcohol, vinyl butyral, vinyl chloride, vinyl chloride-acetate copolymer, vinylidene chloride and vinyl formal.

Thermosetting resins include, but are not limited to allyl phthalate, furane, melamine-formaldehyde, phenol-formaldehyde and phenol-furfural copolymers, alone or compounded with butadiene acrylonitrile copolymers or acrylonitrile-butadiene-styrene copolymers, polyacrylic esters, silicones, urea formaldehydes, epoxy resins, allyl resins, glyceryl phthalates and polyesters.

Porous materials include, but are not limited to paper, wood, fiberglass, cloth and fibers, such as natural and synthetic fibers, such as cotton fibers and polyester fibers.

The electroless copper compositions may be used to plate both low and high T_{g} resins. Low T_{g} resins have a T_{g} below 160° C and high T_{g} resins have a T_{g} of 160° C and above. Typically high T_{g} resins have a T_{g} of 160° C to 280° C or such as from 170° C to 240° C. High T_{g} polymer resins include, but are not limited to polytetrafluoroethylene (PTFE) and polytetrafluoroethylene blends. Such blends include, for example, PTFE with polyphenylene oxides and cyanate esters. Other classes of polymer resins which include resins with a high T_{g} include, but are not limited to: epoxy resins, such as difunctional and multifunctional epoxy resins, bimaleimide/triazine and epoxy resins (BT epoxy), epoxy/polyphenylene oxide resins, acrylonitrile butadienestyrene, polycarbonates (PC), polyphenylene oxides (PPO), polypheneylene ethers (PPE), polyphenylene sulfides (PPS), polysulfones (PS), polyamides, polyesters such as polyethyleneterephthalate (PET) and polybutyleneterephthalate (PBT), polyetherketones (PEEK), liquid crystal polymers, polyurethanes, polyetherimides, epoxies and composites thereof.

The electroless compositions may be used to deposit copper on walls of through-holes or vias of printed circuit board substrates as well as other parts of the boards. The electroless compositions may be used in both horizontal and vertical processes of manufacturing printed circuit boards.

In general, the boards may be rinsed with water and cleaned and degreased followed by desmearing the through-hole walls. Typically prepping or softening the dielectric or desmearing of the through-holes begins with application of a solvent swell. Any conventional solvent swell may be used. The specific type may vary depending on the type of dielectric material. Minor experimentation may be done to determine which solvent swell is suitable for a particular dielectric material. Solvent swells include, but are not limited to glycol ethers and their associated ether acetates. Examples of commercially available solvent swells are CIRCUPOSIT™ Conditioner 3302A, CIRCUPOSIT™ MLB Conditioner 211, CIRCUPOSIT™ Hole Prep 3303 and CIRCUPOSIT™ Hole Prep 4120 solutions (available from Dow Electronic Materials).

After the solvent swell, a promoter may be applied. Conventional promoters may be used. Such promoters include sulfuric acid, chromic acid, alkaline permanganate or plasma etching. Typically alkaline permanganate is used as the promoter. Examples of commercially available promoters are CIRCUPOSIT™ Promoter 4130, CIRCUPOSIT™ MLB Promoter 213-A and CIRCUPOSIT™ MLB Promoter 3308 solutions (available from Dow Electronic Materials). Optionally, the substrate and through-holes are rinsed with water.

A neutralizer may then be applied to neutralize any residues left by the promoter. Conventional neutralizers may be used. Typically the neutralizer is an aqueous acidic solution containing one or more amines or a solution of 3wt% hydrogen peroxide and 3wt% sulfuric acid. An example of a commercially available neutralizer is CIRCUPOSIT™ MLB Neutralizer 216-5. Optionally, the substrate and through-holes are rinsed with water and then dried.

After neutralizing an acid or alkaline conditioner is applied. Conventional conditioners may be used. Such conditioners may include one or more cationic surfactants, non-ionic surfactants, complexing agents and pH adjusters or buffers. Examples of commercially available acid conditioners are CIRCUPOSIT™ Conditioners 3320A and 3327 solutions (available from Dow Electronic Materials). Suitable alkaline conditioners include, but are not limited to: aqueous alkaline surfactant solutions containing one or more quaternary amines and polyamines. Examples of commercially available alkaline surfactants are CIRCUPOSIT™ Conditioner 231, 3325, 3323A, 813 and 860 formulations. Optionally, the substrate and through-holes are rinsed with water.

Conditioning may be followed by micro-etching. Conventional micro-etching compositions may be used. Micro-etching is designed to provide a micro-roughened metal surface on exposed metal (e.g., innerlayers and surface etch) to enhance subsequent adhesion of plated electroless metal and later electroplate. Micro-etches include, but are not limited to 60 g/L to 120 g/L sodium persulfate or sodium or potassium oxymonopersulfate and sulfuric acid (2%) mixture, or generic sulfuric acid/hydrogen peroxide. Examples of commercially available micro-etching compositions are CIRCUPOSIT™ Microetch 3330 Etch solution and PREPOSIT™ 748 Etch solution (available from Dow Electronic Materials). Optionally, the substrate is rinsed with water.

Optionally, a pre-dip may then applied to the micro-etched substrate and through-holes. Pre-dips include, but are not limited to organic salts such as sodium potassium tartrate or sodium citrate, 0.5% to 3% sulfuric acid or an acidic solution of 25 g/L to 75 g/L sodium chloride.

A catalyst may then be applied to the substrate. Conventional catalysts may be used such as conventional tin/palladium colloidal catalysts. Commercially available catalysts include, but are not limited to CATAPOSIT™ 44 and CATAPOSIT™ 404 catalyst formulations (available from Dow Electronic Materials). Application may be done by conventional methods used in the art, such as immersing the substrate in a solution of the catalyst or by spraying or by atomization using conventional apparatus. Catalyst dwell time may range from 1 minute to 10 minutes, typically from 2 minutes to 8 minutes for vertical equipment and for 25 seconds to 120 seconds for horizontal equipment. The catalysts may be applied at temperatures from room temperature to 80 °C, typically from 30 °C to 60 °C. The substrate and through-holes optionally may be rinsed with water after application of the catalyst.

The substrate and walls of the through-holes are then electrolessly plated with metal using the electroless metal composition. Plating times and temperatures may be conventional. Typically metal deposition may be done at temperatures of 20 °C to 80 °C, more typically from 30 °C to 60 °C. The substrate may be immersed in the electroless plating composition or the electroless composition may be sprayed onto the substrate. Typically, electroless plating may be done for 5 seconds to 30 minutes; however, plating times may vary depending on the thickness of the metal desired.

Optionally anti-tarnish may be applied to the metal. Conventional anti-tarnish compositions may be used. An example of anti-tarnish is ANTI TARNISH™ 7130 solution (available from Dow Electronic Materials). The substrate may optionally be rinsed with water and then the boards may be dried.

After the substrate is plated with copper, the substrates may undergo further processing. Further processing may include conventional processing by photoimaging and further metal deposition on the substrates such as electrolytic metal deposition of, for example, copper, copper alloys, tin and tin alloys.

The combination of the one or more tertiary amines and glyoxylic acid, salts or mixtures thereof provide a stable electroless metal plating composition which is formaldehyde-free and environmentally friendly. The tertiary amines inhibit the decomposition of glyoxylic acids and its salts, thus prolonging the life of the plating composition and reducing the cost of the operation of the plating composition as replacement with glyoxylic acid or its salts is reduced or eliminated. The combination of the one or more tertiary amines, salts, halides or mixtures thereof and the glyoxylic acid, salts or mixtures thereof at the molar ratios provides for a more efficient electroless metal plating process than many conventional electroless metal compositions and plating processes. In addition, the plating compositions may provide for substantially uniform, bright metal deposits on substrates and reduced skip plating.

The following examples are not intended to limit the scope of the invention but to further illustrate it.

### Example 1

Glyoxylic acid-reduced electroless copper plating compositions were prepared as shown below. The compositions included copper ions, glyoxylic acid as reducing agent, potassium tartrate as copper complexing agent, potassium hydroxide as pH adjusting agent, suppressors of glyoxylic acid decomposition, and 2,2'-dipyridyl as stabilizer. The electroless copper compositions were free of formaldehyde. They were tested for the quality of their copper deposits and the stability of the glyoxylic acid.

**Table 1**

| **COMPONENT** | **AMOUNT** | | | |
|---|---|---|---|---|
| | **Formulation 1** | **Formulation 2** | **Formulation 3** | **Formulation 4** |
| Copper ions from copper chloride | 2 g | 2 g | 2 g | 2 g |
| Glyoxylic acid | 7 g | 7 g | 7 g | 7 g |
| Potassium tartrate | 30 g | 30 g | 30 g | 30 g |
| Potassium hydroxide | 15 g | 15 g | 15 g | 15 g |
| Triethanolamine | 12 g (0.08 M) | \ | \ | \ |
| Nitrilotriacetic acid | \ | 20 g (0.1 M) | \ | \ |
| Triisopropanolamine | \ | \ | 16 g (0.08 M) | \ |
| *N,N,N',N'-*tetrakis(2-hydroxypropyl) ethylenediamine | \ | \ | \ | 15 g (0.05 M) |
| 2,2'-dipyridyl | 10 ppm | 10 ppm | 10 ppm | 10 ppm |
| Water | To one liter | To one liter | To one liter | To one liter |

### Example 2

The temperature of the composition of Formulation 1 of Table 1 was maintained at 40 °C and the pH of the composition was 13 during electroless copper deposition. Copper was deposited on substrates for 5 minutes. The substrates used were unclad S1141 epoxy/glass laminates with dimensions 5 cm x 5 cm and copper-clad S1141 epoxy/glass multi-laminate boards (six layers) with dimensions 2 cm x 3.5 cm obtained from Shengyi Technology Co., Ltd. The former were used for measuring the deposition rate, and the latter were used for evaluating the backlight performance of the through-holes. The drill smear and other impurities of the through-holes in each board were then removed in a vertical desmear line process as follows:
1. The boards were treated with solvent swell composed of 12.5% CIRCUPOSIT™ MLB CONDITIONER 211 solution for 5 minutes at 75 °C.
2. Each board was then rinsed with cold water for 3 minutes.
3. The boards were then treated with an alkaline promoter of aqueous alkaline permanganate composed of 10% CIRCUPOSIT™ MLB PROMOTER 213-A solution for 10 minutes at 80 °C.
4. Each board was then rinsed with cold water for 3 minutes.
5. The boards were then treated with an aqueous neutralizer composed of 5% CIRCUPOSIT™ MLB NEUTRALIZER 216-5 solution for 5 minutes at 40 °C.
6. Each board was then rinsed with cold water for 3 minutes.
7. The surface of each board/laminate was immersed in an aqueous bath containing 3% CIRCUPOSIT™ CONDITIONER 3323A solution for 5 minutes at 40 °C.
8. Each board/laminate was then rinsed with cold water for 4 minutes.
9. The through-holes of each board were then microetched with an aqueous acidic solution of 100 g/L sodium persulfate and 2% v/v sulfuric acid at room temperature for 1 minute.
10. Each board was then rinsed with cold water for 3 minutes.
11. A pre-dip was then applied to each board/laminate for 1 minute at room temperature. The pre-dip was CATAPREP™ 404 solution obtained from Rohm and Haas Electronic Materials.
12. The boards/laminates were then primed for 5 minutes at 40 °C with a catalyst bath for electroless copper metallization. The catalyst bath contained 2% CATAPOSIT™ 44 solution, which was obtained from Rohm and Haas Electronic Materials.
13. The boards/laminates were then rinsed with cold water for 2 minutes.
14. The boards/laminates were then activated with 2.5% ACCELERATOR™ 19E solution at room temperature for 2 minutes.
15. The boards/laminates were then rinsed with cold water for 2 minutes.
16. Each board/laminate was then immersed in the electroless copper plating composition of Formulation 1 for electroless copper deposition. The copper deposition was done for 5 minutes at 40 °C at a pH of 13.
17. Each copper plated board/laminate was then rinsed with cold water for 2 minutes.
18. Each copper plated board/laminate was then rinsed with deionised water for 1 minute.
19. After blow-drying, each laminates was observed for the quality of copper deposits, and the deposition rate was then measured by a wet titration method.
20. Each board was then sectioned laterally to expose the copper plated walls of the through-holes. Multiple lateral sections 1 mm thick were taken from the walls of the sectioned through-holes of each board to determine the through-hole wall coverage for the boards using the conventional European Backlight Grading Scale from 0 to 5, where 0 means the worst results and 5 the best results. Reference samples showing results from 0 to 5 are shown in the Figure. Each lateral section was placed under a conventional optical microscope of 50X magnification with a light source. The light was applied to the backside of the sample. If no light was observed, the sample was completely copper plated and the image under the microscope was black as shown in reference sample marked 5.0 of the Figure. If some light was observed, the lateral section was compared to the reference samples marked 0.0 to 4.5. The more light which passed through the sample the lower the backlight rating and the poorer the plating quality. The S 1141 copper plated boards had average backlight values of 4.0 which was an acceptable value for commercial backlight values.
   To evaluate the stability of the reducing agent, glyoxylic acid concentrations were determined by a wet titration method. The bath solution mentioned above was idled at 40 °C with air agitation. The glyoxylic acid concentrations were then measured after 6 hours and the percentage of remaining glyoxylic acid in the bath was calculated. The following method was used to calculate the glyoxylic acid concentrations:
   a) Pipetted 5 mL testing solution into 250 ml beaker and added approximately 50 mL RO water.
   b) Titrated to pH=10.0 with standardized 0.1 N HCl and added 15 mL 0.1 M sodium sulfite or 1-2 g sodium sulfite solid using a conventional pH meter.
   c) Stirred for 3-5 minutes to ensure complete reaction between the glyoxylic acid and sodium sulfite.
   d) Titrated the generated sodium hydroxide with 0.1 N HCl to pH=10.0 and recorded mLs delivered. This titrant represented the glyoxylic acid concentration.
      CHOCOOH(g/L)=mL of HCl×0.1×74/sample size(5mL).
   After 6 hours idling, there was still 54 % glyoxylic acid left, and no copper oxide was observed. Thus the electroless copper composition was stable.
21. The copper deposits obtained from the bath composition of Formulation 1 were salmon pink. Minor amounts of skip plating were observed. The deposition rate measured was 0.19 µm/5 minutes. The amount of copper plated was determined by the following wet titration procedure: First, the copper deposit on the laminate was completely dissolved, and then a buffer solution containing ammonium chloride pH=10 was added to the solution followed by titrating with 0.05 M EDTA standard solution. Thus, the total mass of copper deposit was calculated.

### Example 3

Formulations 2 to 4 of Table 1 were processed in the same way as Example 1. The temperature of the compositions was maintained at 40 °C and a pH of 13 during electroless copper deposition. Copper was deposited on substrates for 5 minutes.

When nitrilotriacetic acid, Formulation 2, was employed as suppressor of glyoxylic acid decomposition, it was found that the copper deposits were salmon pink, smooth and there was no observable skip plating. The highest deposition rate achieved was 0.21 µm/5 minutes. The S1141 copper plated boards had average backlight values of 4.25. After 6 hours idling, there was still 41% glyoxylic acid left, and no copper oxide was observed. Thus the electroless copper composition was stable.

When triisopropanolamine, Formulation 3, was used as suppressor of glyoxylic acid decomposition, it was found that the copper deposits were red and smooth. No skip plating was observed. The deposition rate was 0.33 µm/5 minutes. The S1141 copper plated boards had average backlight values of 4.25. After 6 hours idling, there was still 56% glyoxylic acid left. No copper oxide was observed. Thus the electroless copper composition was stable.

In Formulation 4, *N,N,N',N'*-tetrakis(2-hydroxypropyl) ethylenediamine was used to suppress the glyoxylic acid decomposition. The results showed that the copper deposits were red and smooth and no skip plating was observed. The deposition rate was 0.32 µm/5 min. The S 1141 copper plated boards had average backlight values of 3.5. After 6 hours idling, there was still 65% glyoxylic acid left, and no copper oxide was observed. Thus the electroless copper composition was stable.

Although there was some variation in the parameters tested for Formulations 2-4, they all showed many positive attributes. All of the formulations appeared free of copper oxide, the copper deposits were smooth and no skip plating was observed. With the exception of Formulation 2, the plating rates were on the upper range desired for electroless plating; however, Formulation 2 had a bright, salmon pink deposit. Formulations 2 and 3 showed good backlight performance and were in the acceptable commercial range. After 6 hours idling tine both Formulations 3 and 4 retained over 50% of the original glyoxylic acid added.

### Example 4 (Comparative)

The following electroless copper plating solution was prepared:

**Table 2**

| **COMPONENT** | **AMOUNT** | |
|---|---|---|
| | **Formulation 5** | **Formulation** 6 |
| Copper ions | 2 g | 2 g |
| Formaldehyde | 3 g | / |
| Glyoxylic acid | / | 7 g |
| Potassium tartrate | 30 g | 30 g |
| Potassium hydroxide | 15 g | 15 g |
| Water | To one liter | To one liter |

Formulations 5 and 6 of Table 2 were blank controls of formaldehyde and glyoxylic acid as reducing agents for copper. No reducing agent decomposition suppressors were added into the bath solutions. The temperature of the solutions was maintained at 40 °C and a pH of 13 during the idling test with air agitation. After 6 hours about 69% of the formaldehyde remained, and no copper oxide was observed. This suggested the electroless copper composition was stable, and decomposition of formaldehyde by the Cannizzaro reaction was not a serious issue.

In contrast, Formulation 6 which included glyoxylic acid only had 20% glyoxylic acid left after 6 hours idling. The decomposition rate of glyoxylic acid was very rapid such that from a practical production point of view, glyoxylic acid would not be a suitable substitute for formaldehyde. The rapid decomposition of glyoxylic acid would result in sudden termination of electroless plating and high cost for replenishing the reducing agent. This is one of the main barriers for application of glyoxylic acid as a reducing agent in electroless copper plating solutions.

### Example 5 (Comparative)

Three electroless copper plating solutions were prepared as shown in Table 3 below.

**Table 3**

| **COMPONENT** | **AMOUNT** | | |
|---|---|---|---|
| | **Formulation 7** | **Formulation 8** | **Formulation 9** |
| Copper ions | 2 g | 2 g | 2 g |
| Glyoxylic acid | 7 g | 7 g | 7 g |
| Potassium tartrate | 30 g | 30 g | 30 g |
| Potassium hydroxide | 15 g | 15 g | 15 g |
| Potassium stannate | 6 g | / | / |
| Hexamethylenediamine | / | 2.5 g | / |
| Succinic acid | / | / | 100 ppm |
| Water | To one liter | To one liter | To one liter |

Formulations 7 and 8 included two conventional Cannizzaro reaction-suppressing agents, potassium stannate and hexamethylenediamine, respectively. Their molar concentrations were around 0.02 M. The temperature of the solutions was maintained at 40 °C and a pH of 13 during the idling test with air agitation. After 6 hours of idling, only about 20% glyoxylic acid remained in each solution. This is substantially the same as the electroless copper plating solution of Formulation 6 where no Cannizzaro reaction-suppressing agent was added. The conventional Cannizzaro reaction-suppressing agents, potassium stannate and hexamethylenediamine, did not effectively suppress glyoxylic acid decomposition.

In Formulation 9, succinic acid, another conventional Cannizzaro reaction-suppressing agent was tested. The temperature of the composition was maintained at 40 °C with a pH of 13 during the idling test with air agitation. After 6 hours, only around 20% glyoxylic acid remained. As with Formulations 7 and 8 the succinic acid did not effectively suppress the Cannizzaro reaction.

### Example 6 (Comparative)

Two electroless copper plating formulations were prepared as shown in Table 4 below.

**Table 4**

| **COMPONENT** | **AMOUNT** | |
|---|---|---|
| | **Formulation 10** | **Formulation 11** |
| Copper ions | 2 g | 2 g |
| Formaldehyde | 3 g | / |
| Glyoxylic acid | / | 7 g |
| Potassium tartrate | 30 g | 30 g |
| Potassium hydroxide | 15 g | 15 g |
| Triethylamine | 8.1 g (0.08 M) | / |
| N,N,N',N'-Tetramethylethylenediamine | / | 9.3 g (0.08 M) |
| Water | To one liter | To one liter |

Formulations 10 and 11 included triethylamine and N,N,N',N'-tetramethylethylenediamine, respectively, as suppressors of glyoxylic acid decomposition. Both are tertiary amines; however, none of the alkyl groups was substituted by functional groups, such as carboxylic acid, carboxylate, hydroxyl or phosphonic acid. The temperature of the composition was maintained at 40 °C with a pH of 13 during the idling test with air agitation. After 6 hours idling time only around 21 % glyoxylic acid remained. This was substantially the same as the control solution of Formulation 6 in Example 4 which had 20% remaining. The two unsubstituted tertiary amines did not show acceptable glyoxylic acid decomposition suppression.

### Example 7

A plurality of electroless copper plating solutions was prepared as shown in Table 5 below. The glyoxylic acid decomposition suppressor was triisopropanolamine. The molar ratio of the triisopropanolamine to glyoxylic acid was varied with the remainder of the components kept at the same concentration in the eleven formulations.

**Table 5**

| Formulation | Molar ratio TIPA:GA | Triisopropanolamine (TIPA) | Glyoxylic acid (GA) | Copper ions | Potassium tartrate | Potassium hydroxide | 2,2'-dipyridyl |
|---|---|---|---|---|---|---|---|
| 12-1 | 0:1 | 0 g/L | 7 g/L (0.1 M) | 2 g/L | 30 g/L | 15 g/L | 10 ppm |
| 12-2 | 0.05:1 | 0.96 g/L (0.005 M) | 7 g/L (0.1 M) | 2 g/L | 30 g/L | 15 g/L | 10 ppm |
| 12-3 | 0.2:1 | 3.83 g/L (0.02 M) | 7 g/L (0.1 M) | 2 g/L | 30 g/L | 15 g/L | 10 ppm |
| 12-4 | 0.8:1 | 15.3 g/L (0.08 M) | 7 g/L (0.1 M) | 2 g/L | 30 g/L | 15 g/L | 10 ppm |
| 12-5 | 1.6:1 | 30.6 g/L (0.16 M) | 7 g/L (0.1 M) | 2 g/L | 30 g/L | 15 g/L | 10 ppm |
| 12-6 | 3:1 | 57.4 g/L (0.3 M) | 7 g/L (0.1 M) | 2 g/L | 30 g/L | 15 g/L | 10 ppm |
| 12-7 | 5:1 | 95.6 g/L (0.5 M) | 7 g/L (0.1 M) | 2 g/L | 30 g/L | 15 g/L | 10 ppm |
| 12-8 | 10:1 | 191.3 g/L (1M) | 7 g/L (0.1 M) | 2 g/L | 30 g/L | 15 g/L | 10 ppm |
| 12-9 | 15:1 | 286.9 g/L (1.5 M) | 7 g/L (0.1 M) | 2 g/L | 30 g/L | 15 g/L | 10 ppm |
| 12-10 | 20:1 | 382.6 g/L (2.0 M) | 7 g/L (0.1 M) | 2 g/L | 30 g/L | 15 g/L | 10 ppm |
| 12-11 | 30:1 | 573.9 g/L (3.0 M) | 7 g/L (0.1 M) | 2 g/L | 30 g/L | 15 g/L | 10 ppm |

### Example 8

The electroless copper plating solutions of Example 7 were tested for their plating performance and stability. The substrates used were of the same type as in Example 2 above. The substrates were treated and electroless plated as described in Example 2. The temperature of the plating solutions was maintained at 40 °C with a pH of 13 during electroless copper deposition. Copper was deposited on the substrates for 5 minutes. The results are shown in Table 9.

**Table 9**

| Formulation | Molar ratio TIPA:GA | Deposition rate (µm/5min) | Appearance /Coverage | Bath solution | Bath stability |
|---|---|---|---|---|---|
| 12-1 | 0:1 | 0.31 | Salmon pink; complete deposit | Dark blue, transparent | Good |
| 12-2 | 0.05:1 | 0.3 | Salmon pink; complete deposit | Dark blue with a slightly of purple, transparent | Good |
| 12-3 | 0.2:1 | 0.27 | Salmon pink; complete deposit | Dark blue with a slightly of purple, transparent | Good |
| 12-4 | 0.8:1 | 0.33 | Salmon pink; complete deposit | Dark blue with a slightly of purple, transparent | Good |
| 12-5 | 1.6:1 | 0.32 | Salmon pink; complete deposit | Dark blue with a slightly of purple, transparent | Good |
| 12-6 | 3:1 | 0.35 | Salmon pink; complete deposit | Dark blue with a slightly of purple, transparent | Good |
| 12-7 | 5:1 | 0.41 | Salmon pink; complete deposit | Dark blue with a slightly of purple, transparent | Good |
| 12-8 | 10:1 | 0.42 | Salmon pink; complete deposit | Dark blue with a slightly of purple, transparent | Good |
| 12-9 | 15:1 | 0.33 | Red and dark, complete deposit | Dark blue with a slightly of purple, transparent | Good |
| 12-10 | 20:1 | 0.26 | Red and dark, complete deposit | Dark blue, a slightly viscous and turbid | Good |
| 12-11 | 30:1 | 0.21 | Red and dark, complete deposit | Dark blue, viscous and turbid | Partly plated out after plating |

When the molar ratio of TIPA:GA was varied from 0:1 to 10:1, all of the plating solutions were transparent, dark blue and with a slight of purple color. The deposits were salmon pink without any observable skip plating. As the molar ratio of TIPA:GA increased from 15:1 and greater, the deposits' appearance became darker. This indicated that the deposits' morphology became rougher. When the molar ratio reached 30:1, complete coverage of the substrate was achieved but the deposit was dark and red and the solution was viscous and turbid. What was worse was that the plating solution started to partly plate out after plating. The deposition rate gradually increased with increasing the triisopropanolamine concentration; however, beyond the molar ratio of 10:1, the deposition rate decreased with the increasing concentration.

### Example 9

A plurality of electroless copper plating solutions was prepared as shown in Table 10 below. The glyoxylic acid decomposition suppressor was tiisopropanolamine. The molar ratio of the triisopropanolamine to glyoxylic acid was varied with the remainder of the components kept at the same concentration in the nine formulations.

**Table 10**

| Formulations | Molar ratio TIPA:GA | Triisopropanolamine (TIPA) | Glyoxylic acid (GA) | Copper ions | Potassium tartrate | Potassium hydroxide |
|---|---|---|---|---|---|---|
| 13-1 | 0:1 | 0 g/L | 7 g/L (0.1 M) | 2 g/L | 30 g/L | 15 g/L |
| 13-2 | 0.05:1 | 0.96 g/L (0.005 M) | 7 g/L (0.1 M) | 2 g/L | 30 g/L | 15 g/L |
| 13-3 | 0.1:1 | 1.82 g/L (0.01 M) | 7 g/L (0.1 M) | 2 g/L | 30 g/L | 15 g/L |
| 13-4 | 0.2:1 | 3.83 g/L (0.02 M) | 7 g/L (0.1 M) | 2 g/L | 30 g/L | 15 g/L |
| 13-5 | 0.4:1 | 7.66 g/L (0.04 M) | 7 g/L (0.1 M) | 2 g/L | 30 g/L | 15 g/L |
| 13-6 | 0.8:1 | 15.3 g/L (0.08 M) | 7 g/L (0.1 M) | 2 g/L | 30 g/L | 15 g/L |
| 13-7 | 1.6:1 | 30.6 g/L (0.16 M) | 7 g/L (0.1 M) | 2 g/L | 30 g/L | 15 g/L |
| 13-8 | 5:1 | 95.6 g/L (0.5 M) | 7 g/L (0.1 M) | 2 g/L | 30 g/L | 15 g/L |
| 13-9 | 10:1 | 191.3 g/L (1 M) | 7 g/L (0.1 M) | 2 g/L | 30 g/L | 15 g/L |

### Example 10

The temperature of the plating solutions was maintained at 40 °C with a pH of 13 and air agitation. The remaining glyoxylic acid was measured after 6 hours idling. The results are shown in Table 11.

**Table 11**

| Formulations | Molar ratio TIPA:GA | The remaining glyoxylic acid (%) |
|---|---|---|
| 13-1 | 0:1 | 19 |
| 13-2 | 0.05:1 | 25 |
| 13-3 | 0.1:1 | 27 |
| 13-4 | 0.2:1 | 36 |
| 13-5 | 0.4:1 | 44 |
| 13-6 | 0.8:1 | 56 |
| 13-7 | 1.6:1 | 61 |
| 13-8 | 5:1 | 59 |
| 13-9 | 10:1 | 58 |

The plating solutions with a molar ratio of TIPA:GA as low as 0.05:1 started showing a suppressing effect on the decomposition of glyoxylic acid. By increasing the concentration of the suppressor, remaining glyoxylic acid gradually increased from 19% where there was no triisopropanolamine in the plating solution to 61% where the ratio of TIPA:GA was 1.6:1. Beyond the molar ratio of 1.6:1, the suppressing capability of the triisopropanolamine tended to stability as shown by the results obtained in Formulations 13-8 and 13-9.

## Claims

1. A composition comprising one or more sources of metal ions, one or more sources of glyoxylic acid, salts or mixtures thereof and one or more tertiary amine compounds, salts, halides or mixtures thereof having a formula: 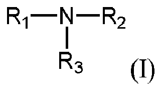 wherein R₁, R₂ and R₃ may be the same or different and are linear or branched, substituted or unsubstituted hydroxy(C₁-C₁₀)alkyl, linear or branched, substituted or unsubstituted carboxy(C₁-C₁₀)alkyl, linear or branched, substituted or unsubstituted (C₁-C₁₀)alkylamine, linear or branched, substituted or unsubstituted (C₁-C₁₀)alkyl phosphonic acid, a moiety having a formula: 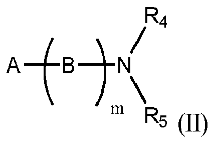 wherein R₄ and R₅ may be the same or different and are linear or branched, substituted or unsubstituted hydroxy(C₁-C₁₀)alkyl, linear or branched, substituted or unsubstituted carboxy(C₁-C₁₀)alkyl, linear or branched, substituted or unsubstituted (C₁-C₁₀)alkylamine, linear or branched, substituted or unsubstituted (C₁-C₁₀)alkyl phosphonic acid, or moiety -(CH₂)ₐ-N-((CH₂)_{b})₂-(P(O)(OH)₂) (IIa) where a and b may be the same or different and are integers of 1 to 6, m is an integer from 1 to 6, B is a moiety having a formula: 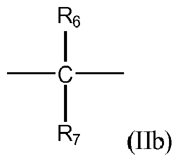 wherein R₆ and R₇ may be the same or different and are hydrogen, hydroxyl, carboxyl, hydroxy(C₁-C₃)alkyl, carboxy(C₁-C₃)alkyl, (C₁-C₃)alkyl, or B may be a substituted or unsubstituted (C₅-C₆)cycloalkyl ring and m = 1, A is a chemical bond with the nitrogen of formula (I) or a moiety having a formula: 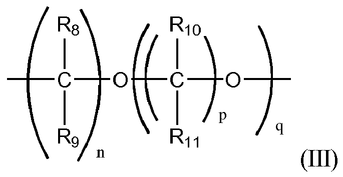 wherein R₈, R₉, R₁₀ and R₁₁ are the same or different and are hydrogen, hydroxyl, (C₁-C₃)alkyl, n, p, q may be the same or different and are integers of 1 to 6, with the proviso that when any two of R₁, R₂ and R₃ are carboxymethyl moieties or salts thereof the third cannot be formula (II) where A is a chemical bond, m is 2, R₆ and R₇ are hydrogen and R₄ and R₅ are carboxymethyl moieties or salts thereof; and a molar ratio of the one or more tertiary amine compounds to the glyoxylic acid or salts thereof is 0.05:1 to 15:1, the compositions are formaldehyde-free.

2. The composition of claim 1, wherein the one or more sources of glyoxylic acid is chosen from non-dissociated glyoxylic acid, dihydroxy acetic acid, a dihaloacetic acid and the bisulphite adduct of glyoxylic acid.

3. The composition of claim 1, wherein the salts of glyoxylic acid are chosen from alkali metal salts and ammonium salt of glyoxylic acid.

4. The composition of claim 1, wherein the one or more tertiary amines are chosen from triethanolamine, 2-[bis(2-hydroxyethyl)amino]acetic acid and its salts, N-(2-hydroxyethyl)iminodiacetic acid and its salts, nitrilotriacetic acid, nitrilo(3-propionic)diacetic acid and its salts, nitrilotripropionic acid and its salts, *N,N-*bis(2-hydroxypropyl)ethanolamine, 1-[bis(2-hydroxyethyl)amino]-2-propanol, 2-[bis(2-hydroxyethyl)amino]-2-(hydroxymethyl) - 1,3-propanediol, *N,N-*Bis(carboxymethyl)-DL-alanine and its salts, triisopropanolamine, L-glutamic acid *N,N'*-diacetic acid and its salts, *N,N,N',N'*-tetrakis(2-hydroxypropyl) ethylenediamine, *N,N,N',N'*-tetrakis(2-hydroxyethyl) ethylenediamine, 1,3-Diamino-2-hydroxypropane-*N,N,N',N'*-tetraacetic acid and its salts, ethylenediaminetetrapropionic acid and its salts, propylenediaminetetraacetic acid and its salts, *N-*(2-hydroxyethyl) ethylenediamine-*N,N',N'*-triacetic acid and its salts, diethylenetriamine pentaacetic acid and its salts, triethylenetetramine-*N,N,N',N",N"',N"'*-hexaacetic acid and its salts, methyl diethanolamine, methyliminodiacetic acid and its salts, tris(carboxymethyl)ethylenediamine, 1,2-diaminocyclohexanetetraacetic acid and its salts, N-(2-aminoethyl)-trans-1,2-diaminocyclohexane-N,N ,N -pentaacetic acid and its salts, ethylene glycol tetraacetic acid and its salts, diethylene triamine pentamethylene phosphonic acid and its salts, (ethylenedinitrilo)-tetramethylenephosphonic acid and its salts, (nitrilotrimethylene) triphosphonic acid and its salts.

5. The composition of claim 1, wherein metal ions are chosen from copper ions, tin ions, nickel ions, silver ions, gold ions and mixtures thereof.

6. The composition of claim 1, further comprising accelerators, uniformity enhancers, stabilizers, grain-refiners, complexing agents, chelating agents, additional reducing agents, pH adjusting agents, antioxidants and surfactants.

7. A method comprising:
a) providing a substrate;
b) applying the composition of claim 1 to the substrate; and
c) electroless plating metal on the substrate.

8. The method of claim 7, wherein the substrate comprises a plurality of through-holes and further comprising:
d) desmearing the through-holes; and
e) plating metal on walls of the through-holes.
